(19) Europäisches Patentamt
European Patent Office
Office européen des brevets

(11) **EP 4 277 443 A1**

(12) **EUROPEAN PATENT APPLICATION**

(43) Date of publication:
**15.11.2023 Bulletin 2023/46**

(21) Application number: **23172082.2**

(22) Date of filing: **08.05.2023**

(51) International Patent Classification (IPC):
**H05K 1/16** $^{(2006.01)}$     **H05K 1/02** $^{(2006.01)}$

(52) Cooperative Patent Classification (CPC):
**H05K 1/162;** H05K 1/0262; H05K 1/0263;
H05K 2201/0352; H05K 2201/0355;
H05K 2201/09309; H05K 2201/09672

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **10.05.2022  IN 202241026865**

(71) Applicant: **Goodrich Aerospace Services Pvt Ltd KR Puram, Hobli Karnataka (IN)**

(72) Inventors:
• **ANANTHARAM, Srinivas Prasad Banavara**
  **560019 Bangalore (IN)**
• **WAGHMARE, Piyush Nilchandra**
  **560037 Kundalhalli, Bangalore (IN)**
• **KEDLAYA, Halladi Shashwatha Kumara**
  **560076 Bangalore (IN)**

(74) Representative: **Dehns**
  **St. Bride's House**
  **10 Salisbury Square**
  **London EC4Y 8JD (GB)**

(54) **CIRCUIT BOARD SYSTEMS AND METHODS**

(57)    In accordance with at least one aspect of this disclosure, a board capacitor (100) can include a first plate (101) formed from a first conductive plane of a circuit board, a dielectric (103) formed by a non-conductive core of the circuit board, and a second plate (105) formed from a second conductive plane of the circuit board. The first plate (101) and the second plate (105) can be separated by the dielectric (103).

Fig. 1

**Description**

**FIELD**

This disclosure relates to circuit boards.

**BACKGROUND**

Certain printed circuit board (PCB) technology allow the calculation of various parameters like parasitic capacitance, inductance, and resistance which helps to predict performance of PCB at the design stage. Typically, such parameters must be accounted for in circuit design and do not present any benefit.

Such conventional methods and systems have generally been considered satisfactory for their intended purpose. However, there is still a need in the art for improved circuit board systems and methods. The present disclosure provides a solution for this need.

**SUMMARY**

In accordance with at least one aspect of this disclosure, a circuit system can include a circuit board that forms a board capacitor that has a defined capacitance, and a circuit associated with the circuit board. The board capacitor can be connected in the circuit of the circuit board.

The circuit board can include a plurality of layers. The board capacitor can be formed by at least a portion of the plurality of layers.

The plurality of layers can comprise a first conductive layer, a second conductive layer, and a non-conductive core layer between the first conductive layer and the second conductive layer. For example, the circuit board can be a multilayer printed circuit board (PCB).

In certain embodiments, at least a portion of the first conductive layer and at least a portion of the second conductive layer form plates of the board capacitor. The non-conductive core can form the dielectric of the board capacitor.

The shape of the first conductive layer and second conductive layer can be selected to provide a desired capacitance. A thickness of the first and second conductive layers can be selected based on a desired current rating. A thickness of the non-conductive core layer can be selected to provide a desired capacitance of the board capacitor.

In certain embodiments, the circuit can be a parallel resonant converter (PRC). In certain embodiments, the circuit can be a series parallel resonant converter (SPRC). The board capacitor can be a tank capacitor, for example. Any other suitable circuit and/or any other suitable capacitor application is contemplated herein for the board capacitor.

In accordance with at least one aspect of this disclosure, a method can include forming a board capacitor out of a portion of two separated conductive planes of a printed circuit board (PCB) to have a desired capacitance. In certain embodiments, the method can include using the board capacitor as a part of a circuit of the PCB.

In certain embodiments, forming the board capacitor can include determining an area of the portions of the two separated conductive planes that form the board capacitor using the following relationship:

$$C = \frac{\varepsilon A}{d} = \frac{k \varepsilon_0 A}{d}, \; where \; \varepsilon_0 = 8.854 \cdot 10^{-12} \frac{F}{m}$$

where C is capacitance, d is separation distance between the two separated conductive planes, k is relative permittivity of a non-conductive core material of the PCB between the two separated conductive planes, and $\varepsilon_0$ is the vaccum permittivity constant. In certain embodiments, forming the board capacitor can include calculating a thickness of the two separated conductive planes of the PCB based on a desired current rating, determining a stack-up of the PCB and/or separation distance between the conductive planes of the PCB based one or more of altitude and voltage isolation, determining the desired capacitance, and calculating an area of the portions of the two separated conductive planes that form the board capacitor.

Forming can include creating the portions of the two separated conductive planes to result in the desired capacitance. The method can include substituting one or more external capacitors with the board capacitor to reduce the size and/or weight of the PCB.

In accordance with at least one aspect of this disclosure, a board capacitor can include a first plate formed from a first conductive plane of a printed circuit board (PCB), a dielectric formed by a non-conductive core of the PCB, and a second plate formed from a second conductive plane of the PCB. The first plate and the second plate can be separated by the dielectric. The first plate and the second plate can be copper, for example. The dielectric can be FR4 material, for example. Any other suitable PCB materials to form a board capacitor is contemplated herein.

These and other features of the embodiments of the subject disclosure will become more readily apparent to those skilled in the art from the following detailed description taken in conjunction with the drawings.

## BRIEF DESCRIPTION OF THE DRAWINGS

So that those skilled in the art to which the subject disclosure appertains will readily understand how to make and use the devices and methods of the subject disclosure without undue experimentation, embodiments thereof will be described in detail herein below with reference to certain figures, wherein:

Fig. 1 is a schematic cross-sectional view of an embodiment of a portion of a circuit board in accordance with this disclosure, shown forming a board capacitor;

Fig. 2 is a schematic diagram of an embodiment of a circuit system in accordance with this disclosure, shown implementing a board capacitor of Fig. 1 in a circuit;

Fig. 3 is a circuit diagram of an embodiment of a parallel resonant circuit, shown implementing the board capacitor of Fig. 1 as a tank capacitor Cr of the circuit;

Fig. 4 is a circuit diagram of an embodiment of a series parallel resonant circuit, shown implementing the board capacitor of Fig. 1 as a tank capacitor Csr of the circuit;

Fig. 5 is a flow diagram of an embodiment of a method in accordance with this disclosure; and

Fig. 6 is a flow diagram of another embodiment of a method in accordance with this disclosure.

## DETAILED DESCRIPTION

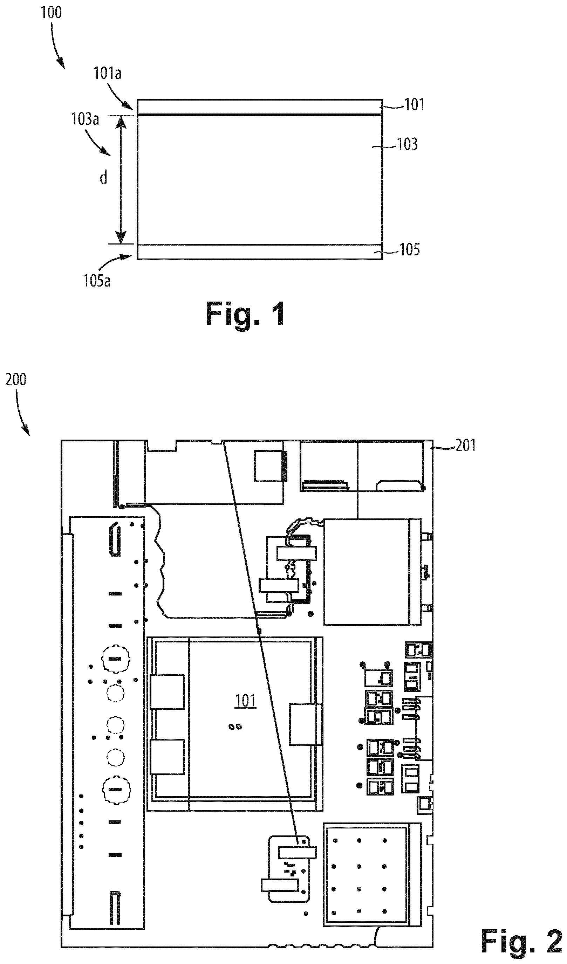

Reference will now be made to the drawings wherein like reference numerals identify similar structural features or aspects of the subject disclosure. For purposes of explanation and illustration, and not limitation, an illustrative view of an embodiment of a circuit board in accordance with the disclosure is shown in Fig. 1 and is designated generally by reference character 100. Other embodiments and/or aspects of this disclosure are shown in Figs. 2-6. Certain embodiments described herein can be used to reduce size and weight of a circuit, and/or reduce part count, increase reliability, and provide additional space on a circuit board.

In accordance with at least one aspect of this disclosure, referring to Figs. 1 and 2, a board capacitor 100 can include a first plate 101 formed from a first conductive plane (e.g., a first conductive layer 101a, e.g., copper plane layer) of a printed circuit board (PCB) 201, a dielectric 103 formed by a non-conductive core (e.g., non-conductive layer 103a, e.g., FR4 material) of the PCB 201, and a second plate 105 formed from a second conductive plane (e.g., a second conductive layer 105a, e.g, a different copper plane layer) of the PCB 201. The first plate 101 and the second plate 105 can be separated by the dielectric 103.

The first plate 101 and the second plate 105 can be copper, for example. Any other suitable material is contemplated herein. The dielectric 103 can be FR4 material, for example, or any other suitable circuit board core material. Any other suitable PCB materials to form a board capacitor is contemplated herein. Any other suitable layering that forms a capacitor structure (e.g., one or more additional layers or sets of layers between the first plate 101 and the second plate 103 are contemplated herein).

Fig. 1 is a schematic cross-sectional view of an embodiment of a portion of a circuit board 201 in accordance with this disclosure, shown forming a board capacitor 100. Fig. 2 is a schematic diagram of an embodiment of a circuit system 200 in accordance with this disclosure, shown implementing the board capacitor 100 of Fig. 1 in a circuit.

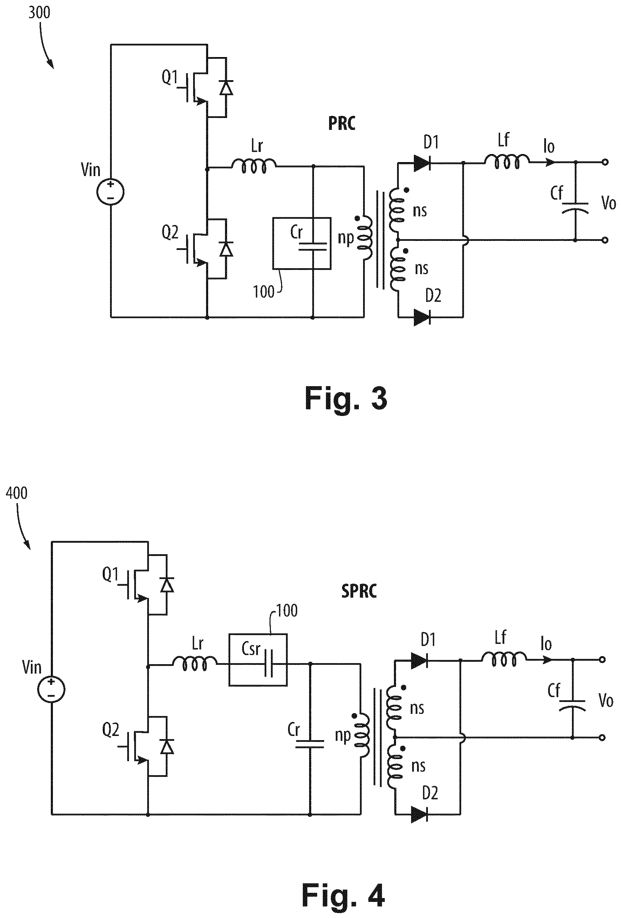

In accordance with at least one aspect of this disclosure, a circuit system 200 can include a circuit board 201 that forms a board capacitor 100 that has a defined capacitance (e.g., a selected intended parasitic capacitance value). Referring additionally to Figs. 3 and 4, the system 200 can also include a circuit 300, 400 associated with the circuit board 201 (e.g., define on, by, and/or within the circuit board 201). The board capacitor 100 can be any suitable board capacitor in accordance with this disclosure, e.g., as disclosed herein, e.g., as described above. The board capacitor 100 can be connected in the circuit 300, 400 of the circuit board 201.

In certain embodiments, the circuit board 201 can include a plurality of layers (e.g., at least three layers as shown in Fig. 1). The board capacitor 100 can be formed by at least a portion of the plurality of layers. For example, the circuit board 201 can be a multilayer printed circuit board (PCB). Any suitable stacking of layers to form a circuit board with one or more board capacitors having a desired capacitance that can be used in lieu of an external capacitor is contemplated herein.

The plurality of layers can comprise a first conductive layer 101a (e.g., a copper plane layer), a second conductive layer 105a (e.g., a copper plane layer), and a non-conductive core layer 103a (e.g., FR4 material layer 103a) between the first conductive layer 101a and the second conductive layer 105a.

In certain embodiments, at least a portion of the first conductive layer 101a and at least a portion of the second conductive layer 105a form plates 101, 105 of the board capacitor 100. For example, the plates 101, 105 can be etched out of the layers 101a, 105a to be a certain size and shape, forming an island in each conductive layer (e.g., as shown in Fig. 2). The non-conductive core layer can form the dielectric 103 of the board capacitor 100. In certain embodiments, the plates 101, 105 can be square shaped. Any other suitable shape is contemplated herein.

The shape of the first conductive layer and second conductive layer (e.g., the portion forming the plates 101, 105 of the board capacitor 100) can be selected to provide a desired capacitance (a suitable amount to replace one or more external capacitors), for example. A thickness of the first and second conductive layers 101a, 105a can be selected based on a desired current rating. A thickness of the non-conductive core layer 103a can be selected to provide a desired capacitance of the board capacitor 100. These sizes and shapes can be tailored to provide the desired capacitance while accounting for other variables as well, e.g., electrical performance, interference, isolation, altitude of use, and/or robustness for example.

Fig. 3 is a circuit diagram of an embodiment of a parallel resonant circuit 300, shown implementing the board capacitor of Fig. 1 as a tank capacitor Cr of the circuit. In certain embodiments, the circuit 300 can be a parallel resonant converter (PRC). Fig. 4 is a circuit diagram of an embodiment of a series parallel resonant circuit 400, shown implementing the board capacitor of Fig. 1 as a tank capacitor Csr of the circuit. In certain embodiments, the circuit can be a series parallel resonant converter (SPRC). The board capacitor 100 can be a tank capacitor, for example. Any other suitable circuit and/or any other suitable capacitor application is contemplated herein for the board capacitor.

In accordance with at least one aspect of this disclosure, a method can include forming a board capacitor out of a portion of two separated conductive planes of a printed circuit board (PCB) to have a desired capacitance. In certain embodiments, the method can include using the board capacitor as a part of a circuit of the PCB.

In certain embodiments, forming the board capacitor can include determining an area of the portions of the two separated conductive planes that form the board capacitor using the following relationship:

$$C = \frac{\varepsilon A}{d} = \frac{k\varepsilon_0 A}{d}, \; where \; \varepsilon_0 = 8.854 \cdot 10^{-12} \frac{F}{m}$$

where C is capacitance, d is separation distance between the two separated conductive planes, k is relative permittivity of a non-conductive core material of the PCB between the two separated conductive planes, and $\varepsilon_0$ is the vaccum permittivity constant. In certain embodiments, forming the board capacitor can include calculating a thickness of the two separated conductive planes of the PCB based on a desired current rating, determining a stack-up of the PCB and/or separation distance between the conductive planes of the PCB based one or more of altitude and voltage isolation, determinining the desired capacitance, and calculating an area of the portions of the two separated conductive planes that form the board capacitor.

Forming can include creating the portions of the two separated conductive planes to result in the desired capacitance. The method can include substituting one or more external capacitors with the board capacitor to reduce the size and/or weight of the PCB. The method can include any other suitable method(s) and/or portion(s) thereof.

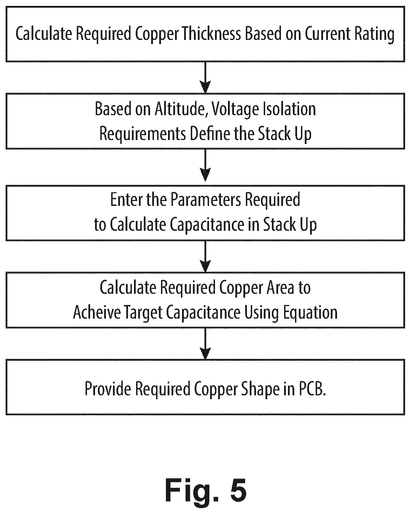

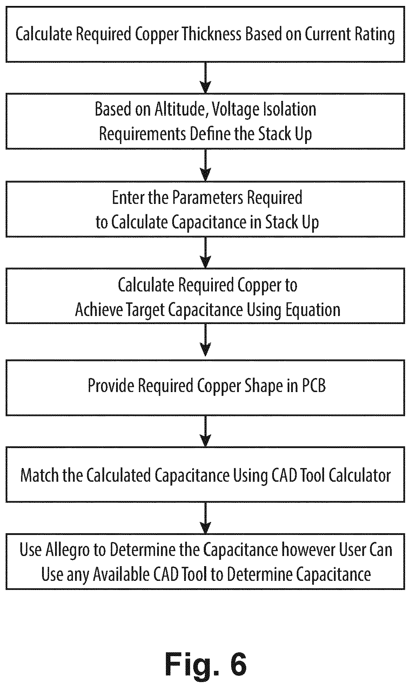

Fig. 5 is a flow diagram of an embodiment of a method in accordance with this disclosure. Fig. 6 is a flow diagram of another embodiment of a method in accordance with this disclosure. As shown, the method of Fig. 6 can include additionally matching capacitance using a CAD tool calculator, and using Allegro PCB software to determine the capacitance after design.

Embodiments can include and/or utilize an integrate board capacitor. Operation at suitably high frequency of switching can allow the capacitor to be very physically small. Embodiments can be applied to any suitable application with suitably small capacitance to not take up to as much physical space or be larger/heavier than external capacitance devices. For example, in certain embodiments, external capacitors can consume about 2 square inches of board space, whereas a board capacitor as disclosed herein having the same capacitance can take up 1 square inch of space and weigh less.

In addition to size and weight savings, performance variation is much lower over external capacitors, causing performance to be better and consistent. Embodiments can eliminate one or more physical external capacitors and use the PCB structure itself as a capacitor. Capacitors can be integrated into the PCB and be formed by copper planes on different layers. Embodiments can be used for as many capacitors on a board where it makes sense or is otherwise desired. Embodiments can include a method that comprises calculating parasitic capacitance to be equal to the desired capacitance for one or more capacitors of a circuit of application.

Embodiments can include using parasitic capacitance of a PCB as a tank element of an LLC Converter. Resonant Converter are gaining popularity due to low switching losses. There are basic three types of topologies existing in resonant converters; a series resonant converter, a parallel resonant converter, and a series parallel resonant converter. In a parallel resonant converter as shown in Fig. 3, the resonant tank capacitor Cr is still in series. It is called parallel resonant converter because in this case the load is in parallel with the resonant capacitor. In a series parallel resonant converter, the resonant tank can include three resonant components; Lr, Csr, and Cpr as shown in Fig. 4. The resonant tank of SPRC can be looked as the combination of SRC and PRC. Similar as PRC, an output filter inductor can be added on secondary side to match the impedance. For SPRC, it can combine the good characteristic of PRC and SRC. With load in series with series tank Lr and Csr, the circulating energy is smaller compared with PRC. With the parallel capacitor Cpr, SPRC can regulate the output voltage at no load condition. The parameters of SPRC designed for front end DC/DC application.

Embodiments can use parasitic capacitance formed by the PCB in the place of Cr of Fig. 3 and Cpr of Fig. 4, for example. This can save the space of capacitor on board and provide the use of parasitic capacitance in design. This presents a cost and time savings as well as the capacitance value of the PCB at the time of converter design can be already calculated as part of the design process.

Electric powered aircraft may require more efficient and consistent power conversion. Variations in magnetic parts used in converters results in low yield and loss of efficiency. Embodiments introduce a method to use parasitic of the magnetics as a component of a circuit, e.g., a converter.

Embodiments include the use of parasitic capacitance between PCB layers for tank circuit of LLC converter to replace the external Cr. Traditionally, LLC converter uses the external capacitor (Csr) in series or parallel way to form a tank circuit. This physical capacitor can be replaced by internal stray capacitance of PCB layers. Capacitance formed by the PCB layers can be calculated using a formula defining "d" as distance between two plates, area of the plate "A", and permittivity $\varepsilon$. For example, using this formula, where distance "d" is gap between layer/layers of PCB "A" area of copper and Permittivity of PCB core or prepreg material, one can determine the parasitic capacitance.

With the help of equation below its possible to determining the parasitic capacitance of a PCB capacitor to obtain a value close to desired amount.

$$C = \frac{\varepsilon A}{d} = \frac{k\varepsilon_0 A}{d}$$

where

$$\varepsilon_0 = 8.854 \cdot 10^{-12} \frac{F}{m}$$

For example, about 4.8 can be the value for the relative permittivity of FR4 PCB material. The distance "d" between two layers of PCB can be fine-tuned to obtain the required results. The value for A can be solved for if the desired capacitance is known, as well as the desired value for d and the permittivity. Values of d can be modified if a desired area is known as well as a desired capacitance. Any other suitable method to calculate characteristics of the board capacitor is contemplated herein.

The capacitor formed by layers of PCB can be used as capacitance of LLC tank and can be tuned to the required capacitance value by the manufacturing process. The tank circuit formed by the leakage inductance and parasitic capacitance can be used as resonant tank circuit for LLC converter. The tank circuit can be tuned to its resonance for better efficiency. The method to determine the parasitic capacitance can include the below.

Once the parameters are selected, the required capacitance can be determine and then PCB can be manufactured to the desired stray capacitance value. Figs. 5 and 6 show embodiments of the steps to calculate capacitance and area required in PCB.

As an example, placement of eight (8) external capacitors can occupy around two square inches of area in a PCB to provide about 220 pF capacitance. If a copper plane of 1 square inch in inner layers of a PCB with dielectric gap of about 4 mils underneath an LLC filter inductor, about 220 pF can be achieved from PCB along with required current rating. By doing so the need for 8 external capacitors is eliminated and space in PCB is freed up, which is a benefit for mounting other related circuit components in PCB or shrinking the overall size.

As demonstrated, external capacitors are not required to achieve the functionality using embodiments of this disclosure. Using certain embodiments, part count and cost is reduced, additional space is available in PCB, the systems are more reliable, and circuit card assembly weight can be reduced. Parasitic capacitance formed by the PCB can be used as part of tank circuit, for example, and dependency on external components can be reduced and be brought under the control of designer.

Embodiments allow users to set one or multiple of these parameters, using the available tools, as a part of an element of a circuit and improve the performance for a better result.

Embodiments provide a reduced weight because external capacitors can be eliminated, reduced assembly cost and time, hence increased productivity. Also, external capacitors are not required to achieve a desired functionality, part procurement and assembly of many components can be eliminated, there can be additional space available in a PCB, embodiments can be more reliable, and a circuit card assembly weight can be reduced.

Embodiments can include any suitable computer hardware and/or software module(s) to perform any suitable function (e.g., as disclosed herein).

As will be appreciated by those skilled in the art, aspects of the present disclosure may be embodied as a system, method or computer program product. Accordingly, aspects of this disclosure may take the form of an entirely hardware embodiment, an entirely software embodiment (including firmware, resident software, micro-code, etc.), or an embodiment combining software and hardware aspects, all possibilities of which can be referred to herein as a "circuit," "module," or "system." A "circuit," "module," or "system" can include one or more portions of one or more separate physical hardware and/or software components that can together perform the disclosed function of the "circuit," "module," or "system", or a "circuit," "module," or "system" can be a single self-contained unit (e.g., of hardware and/or software). Furthermore, aspects of this disclosure may take the form of a computer program product embodied in one or more computer readable medium(s) having computer readable program code embodied thereon.

Any combination of one or more computer readable medium(s) may be utilized. The computer readable medium may be a computer readable signal medium or a computer readable storage medium. A computer readable storage medium may be, for example, but not limited to, an electronic, magnetic, optical, electromagnetic, infrared, or semiconductor system, apparatus, or device, or any suitable combination of the foregoing. More specific examples (a non-exhaustive list) of the computer readable storage medium would include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. In the context of this document, a computer readable storage medium may be any tangible medium that can contain, or store a program for use by or in connection with an instruction execution system, apparatus, or device.

A computer readable signal medium may include a propagated data signal with computer readable program code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

Program code embodied on a computer readable medium may be transmitted using any appropriate medium, including but not limited to wireless, wireline, optical fiber cable, RF, etc., or any suitable combination of the foregoing.

Computer program code for carrying out operations for aspects of this disclosure may be written in any combination of one or more programming languages, including an object oriented programming language such as Java, Smalltalk, C++ or the like and conventional procedural programming languages, such as the "C" programming language or similar programming languages. The program code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of this disclosure may be described above with reference to flowchart illustrations and/or block diagrams of methods, apparatus (systems) and computer program products according to embodiments of this disclosure. It will be understood that each block of any flowchart illustrations and/or block diagrams, and combinations of blocks in any flowchart illustrations and/or block diagrams, can be implemented by computer program instructions. These computer program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in any flowchart and/or block diagram block or blocks.

These computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified herein.

Those having ordinary skill in the art understand that any numerical values disclosed herein can be exact values or can be values within a range. Further, any terms of approximation (e.g., "about", "approximately", "around") used in this disclosure can mean the stated value within a range. For example, in certain embodiments, the range can be within (plus or minus) 20%, or within 10%, or within 5%, or within 2%, or within any other suitable percentage or number as appreciated by those having ordinary skill in the art (e.g., for known tolerance limits or error ranges).

The articles "a", "an", and "the" as used herein and in the appended claims are used herein to refer to one or to more than one (i.e., to at least one) of the grammatical object of the article unless the context clearly indicates otherwise. By way of example, "an element" means one element or more than one element.

The phrase "and/or," as used herein in the specification and in the claims, should be understood to mean "either or both" of the elements so conjoined, i.e., elements that are conjunctively present in some cases and disjunctively present in other cases. Multiple elements listed with "and/or" should be construed in the same fashion, i.e., "one or more" of the elements so conjoined. Other elements may optionally be present other than the elements specifically identified by the "and/or" clause, whether related or unrelated to those elements specifically identified. Thus, as a non-limiting example, a reference to "A and/or B", when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

As used herein in the specification and in the claims, "or" should be understood to have the same meaning as "and/or" as defined above. For example, when separating items in a list, "or" or "and/or" shall be interpreted as being inclusive, i.e., the inclusion of at least one, but also including more than one, of a number or list of elements, and, optionally, additional unlisted items. Only terms clearly indicated to the contrary, such as "only one of" or "exactly one of," or, when used in the claims, "consisting of," will refer to the inclusion of exactly one element of a number or list of elements. In general, the term "or" as used herein shall only be interpreted as indicating exclusive alternatives (i.e., "one or the other but not both") when preceded by terms of exclusivity, such as "either," "one of," "only one of," or "exactly one of."

Any suitable combination(s) of any disclosed embodiments and/or any suitable portion(s) thereof are contemplated herein as appreciated by those having ordinary skill in the art in view of this disclosure.

The embodiments of the present disclosure, as described above and shown in the drawings, provide for improvement in the art to which they pertain. While the subject disclosure includes reference to certain embodiments, those skilled in the art will readily appreciate that changes and/or modifications may be made thereto without departing from the spirit and scope of the subject disclosure.

## Claims

1. A circuit system, comprising:

   a circuit board (201) that forms a board capacitor (100) that has a defined capacitance; and
   a circuit (300, 400) associated with the circuit board (201), wherein the board capacitor (100) is connected in the circuit (300, 400) of the circuit board.

2. The system of claim 1, wherein the circuit board (201) comprises a plurality of layers, wherein the board capacitor (100) is formed by at least a portion of the plurality of layers.

3. The system of claim 1, wherein the plurality of layers comprise a first conductive layer (101a), a second conductive layer (1 05a), and a non-conductive core layer (103a) between the first conductive layer and the second conductive layer.

4. The system of claim 3, wherein the circuit board (201) is a multilayer printed circuit board, PCB.

5. The system of claim 3, wherein at least a portion of the first conductive layer (101a) and at least a portion of the second conductive layer (105a) form plates of the board capacitor (100), and wherein the non-conductive core forms the dielectric of the board capacitor (100).

6. The system of claim 5, wherein the shape of the first conductive layer (101a) and second conductive layer (1 05a) are selected to provide a desired capacitance.

7. The system of claim 6, wherein a thickness of the first and second conductive layers (101a, 105a) are selected based on a desired current rating, and preferably wherein the thickness of the non-conductive core layer (103a) is selected to provide a desired capacitance of the board capacitor (100), and preferably wherein the circuit is a series parallel resonant converter, SPRC, wherein the board capacitor (100) is a tank capacitor.

8. The system of claim 1, wherein the circuit is a parallel resonant converter, PRC, wherein the board capacitor (100) is a tank capacitor.

9. A method, comprising:
forming a board capacitor out of a portion of two separated conductive planes of a printed circuit board, PCB, to have a desired capacitance.

10. The method of claim 9, further comprising using the board capacitor as a part of a circuit of the PCB.

11. The method of claim 9 or 10, wherein forming the board capacitor includes determining an area of the portions of the two separated conductive planes that form the board capacitor using the following relationship:

$$C = \frac{\varepsilon A}{d} = \frac{k \varepsilon_0 A}{d}, \ where \ \varepsilon_0 = 8.854 \cdot 10^{-12} \frac{F}{m}$$

wherein C is capacitance, d is separation distance between the two separated conductive planes, k is relative permittivity of a non-conductive core material of the PCB between the two separated conductive planes, and $\varepsilon_0$ is the vacuum permittivity constant.

12. The method of claim 11, wherein forming includes:

calculating a thickness of the two separated conductive planes of the PCB based on a desired current rating;
determining a stack-up of the PCB and/or separation distance between the conductive planes of the PCB based one or more of altitude and voltage isolation;
determining the desired capacitance; and
calculating an area of the portions of the two separated conductive planes that form the board capacitor, and preferably wherein forming includes creating the portions of the two separated conductive planes to result in the desired capacitance.

13. The method of claim 10, further comprising substituting one or more external capacitors with the board capacitor to reduce the size and/or weight of the PCB.

14. A board capacitor, comprising:

a first plate (101) formed from a first conductive plane of a printed circuit board, PCB;
a dielectric (103) formed by a non-conductive core of the PCB; and
a second plate (105) formed from a second conductive plane of the PCB, wherein the first plate and the second plate are separated by the dielectric.

15. The board capacitor of claim 14, wherein the first plate (101) and the second plate (105) are copper, and preferably wherein the dielectric (103) is FR4 material.

**Fig. 1**

**Fig. 2**

300

Q1

Vin

Q2

PRC

Lr

Cr    np

100

D1    Lf    Io

ns

ns

D2

Cf    Vo

# Fig. 3

400

Q1

Vin

Q2

SPRC

100

Lr    Csr

Cr    np

D1    Lf    Io

ns

ns

D2

Cf    Vo

# Fig. 4

Calculate Required Copper Thickness Based on Current Rating

↓

Based on Altitude, Voltage Isolation
Requirements Define the Stack Up

↓

Enter the Parameters Required
to Calculate Capacitance in Stack Up

↓

Calculate Required Copper Area to
Acheive Target Capacitance Using Equation

↓

Provide Required Copper Shape in PCB.

# Fig. 5

Calculate Required Copper Thickness Based on Current Rating

↓

Based on Altitude, Voltage Isolation
Requirements Define the Stack Up

↓

Enter the Parameters Required
to Calculate Capacitance in Stack Up

↓

Calculate Required Copper to
Achieve Target Capacitance Using Equation

↓

Provide Required Copper Shape in PCB

↓

Match the Calculated Capacitance Using CAD Tool Calculator

↓

Use Allegro to Determine the Capacitance however User Can
Use any Available CAD Tool to Determine Capacitance

# Fig. 6

Europäisches
Patentamt

European
Patent Office

Office européen
des brevets

# EUROPEAN SEARCH REPORT

Application Number

EP 23 17 2082

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 912 809 A (STEIGERWALD TODD W [US] ET AL) 15 June 1999 (1999-06-15) | 1-6, 9-11,14, 15 | INV. H05K1/16 |
| Y | * column 4, line 56 - column 7, line 29; figures 1,3 * <br> * column 8, line 1 - column 9, line 48; figure 6 * <br> ----- | 8 | ADD. H05K1/02 |
| X | US 5 161 086 A (HOWARD JAMES R [US] ET AL) 3 November 1992 (1992-11-03) | 1-7,9-14 | |
| Y | * column 12, line 12 - column 14, line 5; figures 4-5 * <br> * column 9, lines 12-44 * <br> * column 11, lines 1-17; figure 2 * <br> ----- | 8 | |
| Y | EP 3 829 045 A1 (HAMILTON SUNDSTRAND CORP [US]) 2 June 2021 (2021-06-02) * paragraph [0018]; figure 3a * <br> ----- | 8 | |

TECHNICAL FIELDS SEARCHED (IPC)

H05K

The present search report has been drawn up for all claims

| Place of search | Date of completion of the search | Examiner |
|---|---|---|
| The Hague | 29 September 2023 | Tomezak, Alexandre |

EPO FORM 1503 03.82 (P04C01)

## ANNEX TO THE EUROPEAN SEARCH REPORT
## ON EUROPEAN PATENT APPLICATION NO.

EP 23 17 2082

This annex lists the patent family members relating to the patent documents cited in the above-mentioned European search report.
The members are as contained in the European Patent Office EDP file on
The European Patent Office is in no way liable for these particulars which are merely given for the purpose of information.

29-09-2023

| Patent document cited in search report | | Publication date | Patent family member(s) | | Publication date |
|---|---|---|---|---|---|
| US 5912809 | A | 15-06-1999 | NONE | | |
| US 5161086 | A | 03-11-1992 | NONE | | |
| EP 3829045 | A1 | 02-06-2021 | EP | 3829045 A1 | 02-06-2021 |
| | | | US | 2021159803 A1 | 27-05-2021 |

EPO FORM P0459

For more details about this annex : see Official Journal of the European Patent Office, No. 12/82